# EUROPÄISCHE PATENTSCHRIFT

(11) **EP 0 857 518 B1**
(45) Veröffentlichungstag und Bekanntmachung des Hinweises auf die Patenterteilung: **07.05.2003**
(21) Anmeldenummer: 97122226.0
(22) Anmeldetag: 17.12.1997
(51) Int. Cl.: B05D 7/24, G02B 1/10, C23C 14/56, F21V 7/22

(54) **Verfahren und Vorrichtung zur Schutzbeschichtung von Verspiegelungsschichten**
Process and apparatus for protective coating of mirror layers
Procédé et dispositif pour la fabrication de revêtements protecteurs sur des couches réfléchissantes

(30) Priorität: 10.02.1997 DE 19704947
(43) Veröffentlichungstag der Anmeldung: 12.08.1998
(73) Patentinhaber: Leybold Optics GmbH, 63775 Alzenau (DE)
(72) Erfinder: Grünwald, Heinrich, Dr., 61194 Niddatal (DE); Jung, Michael, 63755 Alzenau (DE); Dicken, Wilfried, 63607 Wächtersbach (DE); Kunkel, Stefan, 63457 Hanau (DE); Nauenburg, Klaus, Dr., 63456 Hanau (DE)

(56) Entgegenhaltungen:
- EP-A- 0 678 593
- EP-A- 0 816 529
- WO-A-96/11289
- DE-A- 2 536 013
- DE-A- 2 625 448
- DE-A- 3 413 019
- DE-A- 4 211 962

## Beschreibung

Die Erfindung betrifft ein Verfahren zur beschlaghemmenden Beschichtung auf Korrosionsschutzschichten für Verspiegelungsschichten von Scheinwerferreflektoren mit Hilfe von Plasmapolymerisation und die Vorrichtung zur Durchführung des Verfahrens.

Bekannt ist ein Verfahren zur Schutzbeschichtung von Substraten mittels Plasmapolymerisation mit mindestens einer gasförmigen Silizium-organischen Verbindung, bei dem ein Plasma in einer Vakuumkammer erzeugt wird und ein Gas mit der Verbindung eingespeist wird zur Erzeugung der Beschichtung, wobei das Plasma mittels eines amplitudenmodulierten elektromagnetischen Wechselfeldes erzeugt wird und die Beschichtungsrate mittels mindestens eines diese mitbestimmenden Verfahrensparameters so hoch gestellt wird, daß bei Stillsetzung der Modulation der Amplitude des elektromagnetischen Wechselfeldes und Konstanthalten dessen Amplitude auf Modulationsmaximalwert die erzeugte Schutzschicht wesentliche pulverförmige Anteile aufweist (EP 0 533 044). Dieses bekannte -Verfahren eignet sich besonders zur Schutzbeschichtung mit möglichst hoher Beschichtungsrate bei weitgehend wartungsfreiem Betrieb.

Das genannte Verfahren hat den Nachteil, daß es eine Beschlagsbildung auf der Reflektorschicht aus Luftfeuchtigkeit und/oder Ausschwitzungen des Scheinwerferkonstruktionsmaterials nicht verhindert.

Das Verfahren nach DE 26 25 448 schlägt als Abhilfe eine Hydrophilierung der Schutzbeschichtung mit einem nachfolgenden Sauerstoffplasma vor. Eigene Versuche zeigten jedoch, daß der beschlaghemmende Effekt begrenzt ist. Noch nachteiliger ist, daß durch die Sauerstoffplasmabehandlung die Korrosionsschutzwirkung der Schutzbeschichtung entscheidend beeinträchtigt werden kann. Es ist deshalb Stand der Produktionstechnik, anschließend an die Herstellung der Korrosionschutzschicht (mittels Plasmapolymerisation) mit Hilfe einer speziellen Aufdampfeinrichtung eine Hydrophilschicht aus Siliziummonoxid aufzudampfen. Dies erhöht den Anlagenaufwand beträchtlich, insbesondere bei kurzgetakteten, kontinuierlich betriebenen Mehrkammeranlagen, da hierfür eine zusätzliche Prozeßkammer vorgesehen werden muß.

Der vorliegenden Erfindung liegt deshalb die Aufgabe zugrunde, ein Verfahren und eine Vorrichtung anzugeben, mit deren Hilfe hochwirksame beschlaghemmende Hydrophilschichten auf plasmapolymerisierte Schutzschichten der genannten Art aufgebracht werden können, ohne daß die korrosionsschützende Wirkung der Schutzschichten beeinträchtigt wird. Dabei dürfen keine nachteiligen optischen Effekte wie meßbare Absorption im sichtbaren Bereich oder Interferenzfarben auftreten. Aus Kostengründen soll hierzu ferner dieselbe Vorrichtung verwendet werden, die auch der Herstellung der Schutzschicht dient. Darüber hinaus sollen Verfahren und Vorrichtung zum Einsatz in kontinuierlich betriebenen Produktionsanlagen mit kurzen (typischerweise < 1 min) Zykluszeiten geeignet sein.

Erfindungsgemäß wird diese Aufgabe durch ein Verfahren gelöst, bei dem die in einer Vakuumkammer auf die Verspiegelungsschicht (typischerweise aufgedampftes oder -gesputtertes Aluminium) aufgebrachte, mittels Plasmapolymerisation hergestellte Korrosionsschutzschicht in einem weiteren Verfahrensschritt in der selben Prozeßkammer unter Beibehaltung des Vakuums und unter Anwendung eines Plasmas mit einer zweiten, hydrophilen und beschlaghemmenden Schicht versehen wird, die im wesentlichen aus einem Kohlenwasserstoffgerüst und daran gebundenen polar wirkenden funktionellen Gruppen besteht.

Als Ausgangssubstanz für die plasmapolymerisierte Korrosionsschutzschicht wird dem Stand der Technik entsprechend typischerweise Hexamethyldisiloxan oder aber eine andere, genügend verdampfbare, verwandte siliziumorganische Verbindung verwendet.

Erfindungsgemäß läßt sich die beschlaghemmende Hydrophilschicht nach drei unterschiedlichen Verfahrensvarianten herstellen:

### Verfahrensvariante 1a:

Die Herstellung der beschlaghemmenden Schicht erfolgt durch Plasmapolymerisation unter Einsatz von mindestens einer Ausgangssubstanz, die im wesentlichen aus einem Kohlenwasserstoffanteil und mindestens einer elekronegativen (d.h. im wesentlichen aus elektronegativen Elementen bestehenden) funktionellen Gruppe zusammengesetzt ist. Der Kohlenwasserstoffanteil kann dabei aliphatisch, cycloaliphatisch, aromatisch oder heterozyklisch sein. Als elektronegative funktionelle Gruppen können vorgesehen werden: Halogen- (-F, -Cl, -Br), Sulfid- (-S), Sulfoxy- (=SO-), Sulfon- (=SO₂), Amino- (insbesondere -NH₂ oder =NH, auch als Ring), Ester- (-COOR-), Ether- (C-O-C, auch als Ring, z.B. Oxiran), bevorzugt Carboxi- (-COOH), Carbonyl- (=C=O), Nitril- (-CN), besonders bevorzugt Nitro- (-NO₂), Amido- (-CONH;) oder Hydroxi (-OH)-Gruppen.

Beispiele für geeignete Ausgangssubstanzen sind: Ameisensäure, Essigsäure, Propionsäure, Acrylsäure, Azetaldehyd, Propionaldehyd, Butyraldehyd, i-Butyraldehyd, Methanol, Ethanol, n-Propanol, i-Propanol, Butanol-1, Butanol-2, i-Butanol, t-Butanol, 2-Methyl-2-Propenol, Formamid, Acetonitril, Acrylnitril, Ethylessigester, Crotonsäuremethylester, Dioxan, Tetrahydrofuran, Nitromethan, und Nitroethan.

### Verfahrensvariante 1b:

Die Herstellung der beschlaghemmenden Schicht erfolgt durch Plasmapolymerisation unter Einsatz eines Gemischs aus mindestens einer Kohlenwasserstoffverbindung und einer zusätzlichen Verbindung, die im wesentlichen aus einem oder mehreren elektronegativen Elementen (Halogene, bevorzugt aber Sauerstoff oder Stickstoff) besteht. Als Kohlenwasserstoffverbindungen können offenkettige oder zyklische Alkane, Alkine, oder Aromaten, bevorzugt aber offenkettige oder zyklische Alkene verwendet werden. Als zusätzliche Verbindung wird erfindungsgemäß O₂, CO₂, H₂O, N₂, N₂O, NH₃ oder ein Gemisch dieser Verbindungen, im einfachsten Falle bspw. Luft.

Beispiele für im Sinne der Erfindung einsetzbare Gemische sind: Ethylen + O₂, Azetylen + H₂O oder Cyclopenten + N₂O.

Erfindungsgemäß ist es auch möglich, eine Ausgangssubstanz nach Variante 1a mit einer Kohlenwasserstoffverbindung oder aber einer elektronegativen Zusatzverbindung nach 1b gemeinsam in einen Plasmapölymerisationsprozeß einzusetzen.

Weiter ist es möglich, entsprechend üblicher Praxis in der Plasmatechnik bei beiden oben genannten Verfahrensvarianten dem Plasma ein oder mehrere Edelgase zuzusetzen, um die Eigenschaften des Plasmas bzw. der Schichten günstig zu beeinflussen.

### Verfahrensvariante 2:

Die Bildung der beschlaghemmenden Schicht erfolgt durch plasmainduzierte Polymerisation. Dieses Verfahren beruht auf der Reaktion geeigneter Verbindungen mit Radikalstellen an der Oberfläche der Korrosionsschutzschicht. Diese Radikalstellen werden bekanntermaßen durch Einwirkung eines Plasmas auf Polymeroberflächen erzeugt. Somit werden bei der Herstellung der Korrosionsschutzschicht während der Plasmapolymerisation ständig Radikale in und auf der aufwachsenden Schicht erzeugt, die auch nach Beendigung des Prozesses noch vorhanden sind und im Anschluß weiterreagieren. Es können jedoch auch nach der Plasmapolymerisation durch ein gesondertes, kurzzeitiges Stickstoff- oder Edelgasplasma in und auf der Plasmapolymerschicht Radikale erzeugt werden, die in gleicher Weise reagieren.

Erfindungsgemäß wird nun nach Beendigung eines solchen Edelgasplasmas oder vorteilhaft direkt nach der Plasmapolymerisation der Korrosionsschutzschicht eine oder mehrere aliphatische, cycloaliphatische heterozyklische oder aromatische Ausgangssubstanzen mit jeweils mindestens einer elektronegativen funktionellen Gruppe und mit zusätzlich mindestens einer polymerisierbaren funktionellen Gruppe in die Prozeßkammer eingelassen. Als polymerisierbare Gruppen sind erfindungsgemäß insbesondere C=C-Doppelbindungen, Epoxigruppen oder Thiirangruppen geeignet. Bei Verwendung von Ausgangssubstanzen mit Epoxigruppen bilden sich durch die Reaktion mit den Radikalen polare funktionelle Gruppen, so daß bei nicht allzu hohen Anforderungen an die Hydrophilie der Schicht in diesem Fall auf gesonderte elektronegative Gruppen in den Ausgangssubstanzen verzichtet werden kann. Ansonsten können als elektronegative funktionelle Gruppen eingesetzt werden: Halogen- (-F, -Cl, -Br, -I), Sulfoxy- (=SO-), Sulfon- (=SO₂),Amin-(insbesondere -NH₂), bevorzugt jedoch Carboxi-(-COOH), Carbonyl- (-C=O), Nitril- (-CN), besonders bevorzugt Nitro- (-NO₂), Amid- (-CONH₂) oder Hydroxi(-OH)- Gruppen.

Beispiele für bei dieser Verfahrensvariante einzusetzende Ausgangssubstanzen sind: Propylenoxid, Acrylnitril, Allyl-2,3-epoxipropylether, 2,3-Epoxipropanol, bevorzugt Crotononitril, Acrylsäure, 2-Butenol sowie 1-Buten-3-ol.

Ein typisches Beispiel ist eine kurzzeitige Anwendung eines Argonplasmas nach dessen Abschalten sofort 3-Buten-1-ol in Dampfform in die Reaktionskammer eingelassen wird.

Es findet eine Vorrichtung zur Durchführung des Verfahrens Verwendung mit mehreren, von einer ortsfesten, kreiszylindrischen Vakuumkammerwand gehaltenen Behandlungsstationen und einem von der Vakuumkammerwand umschlossenen, drehbar gelagerten, vier Substratkammern tragenden Innenwandzylinder, wobei in der Wand der Vakuumkammer vier Öffnungen vorgesehen sind, mit denen die Substratkammern in Deckung bringbar sind und durch die die Behandlungsmittel auf die Substrate einwirken können und mit einer die Vakuumkammerwand von außen umschließenden, von der Vakuumkammerwand sich radial nach außen zu erstreckenden, die drei Behandlungsstationen und die Ein-/Ausschleusstation miteinander verbindenden Außenwand, wobei mindestens eine der zwischen der Außenwand, der Vakuumkammerwand und den Behandlungsstationen vorgesehenen Außenkammern einerseits mit einer benachbarten Behandlungsstation und andererseits mit einer Gas- oder Ausgangssubstanz-Quelle verbunden ist.

Weitere Einzelheiten und Merkmale sind in den anhängenden Patentansprüchen näher beschrieben und gekennzeichnet.

Die Erfindung läßt die verschiedensten Ausführungsmöglichkeiten zu; eine davon ist in der anhängenden Zeichnung rein schematisch näher dargestellt, die den Schnitt quer durch die Vakuumbehandlungsanlage zeigt.

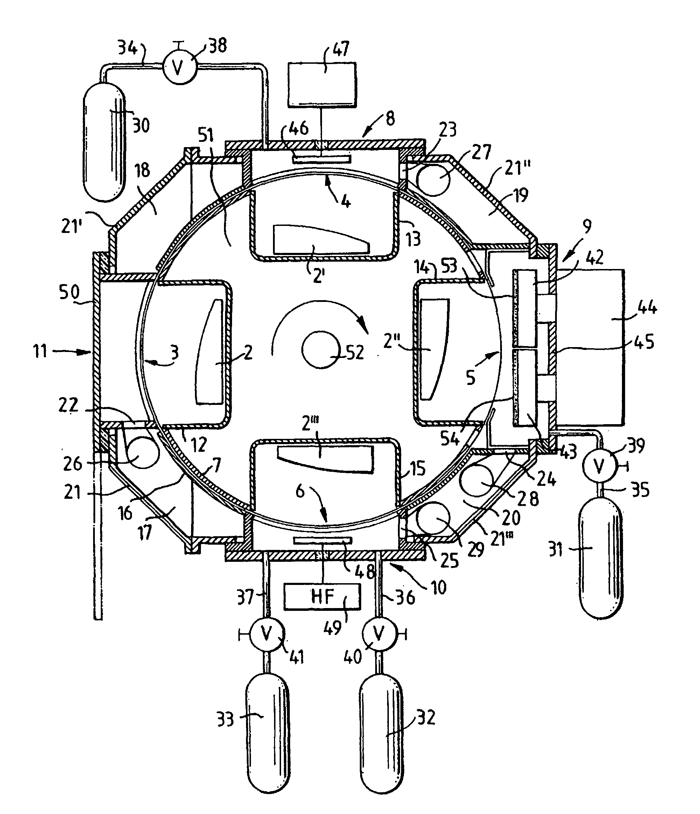

Die Vorrichtung weist eine kreiszylindrische Vakuumkammer 16 auf, die mit mehreren, gleichmäßig auf ihrer Mantelfläche verteilt angeordneten, fensterförmigen Öffnungen 3 bis 6 versehen ist, wobei jeder Öffnung 3 bis 6 eine Behandlungsstation 8,9,10 oder Ein-/Ausschleusstation 11 zugeordnet ist, die jeweils aus einem kastenförmigen, zur jeweiligen Öffnung 3 bis 6 hin offenen Gehäuse 12 bis 15 besteht, dessen umlaufende Randpartie mit der zylindrischen Wand der Vakuumkammer 16 fest verbunden ist. Die zylindrische Vakuumkammer 16 umschließt einen Innenzylinder 7, der mit Öffnungen versehen ist, die mit den zuvor erwähnten Öffnungen 3 bis 6 in der Vakuumkammer 16 korrespondieren und in die die kastenförmigen Substratkammern 12 bis 15 eingesetzt sind, die zusammen mit den Behandlungsstationen 8,9,10 bzw. der Ein-/Ausschleusstation 11 in der in der Zeichnung dargestellten Stellung des Innenzylinders 7 jeweils allseitig geschlossene Behältnisse bilden. Die kreiszylindrische Vakuumkammerwand 16 ist von Außenwandteilen 21,21',21'',... umgriffen, die jeweils fest mit den Wandteilen der Behandlungsstationen 8,9,10 bzw. der Ein-/Ausschleusstation 11 verbunden sind und so zusammen mit der Kammerwand 16 Außenkammern 17,18,19,20 bilden. Alle diese Außenkammern sind über Kanäle 22,23,24,25 einerseits mit den Behandlungsstationen 8,9,10 bzw. 11 und andererseits über Rohrleitungen 26,27,28,29 mit Vakuumpumpen verbunden. Im übrigen sind die Behandlungskammern 8,9,10 mit Gasvorratstanks 30,31,32,33 verbunden, wobei in die Verbindungsleitungen 34,35,36,37 jeweils Ventile 38,39,40,41 eingeschaltet sind, über die die Gase dosiert in die einzelnen Behandlungskammern 8,9,10 eingelassen werden können, so daß beispielsweise in der Behandlungsstation 8 ein Glimm- oder Vorbeschichtungsprozeß und in den Stationen 9 und 10 jeweils Beschichtungsprozesse durchgeführt werden können. Im Gehäuse der Behandlungsstation 9 sind zwei Sputterkathoden 42,43 untergebracht, wobei die erforderliche Stromversorgung 44 an der Außenwand 45 der Behandlungsstation 9 befestigt ist. In der Behandlungsstation 8 ist eine Elektrode (typischerweise als sog. Glimmkathode ausgebildet) 46 vorgesehen, wobei die Stromversorgung 47 an die Glimmkathode angeschlossen ist. Die Behandlungsstation 10 ist mit einer Elektrode 48 ausgestattet, die von einem eigenen Stromgenerator 49 gespeist wird, wobei Ausgangssubstanzen aus den beiden Vorratstanks 32,33 gleichzeitig oder nacheinander über die Leitungen 36,37 dosiert in die Station 10 einlaßbar sind. Zum Zwecke des Ein- bzw. Ausschleusens ist der Deckel in die strichpunktiert eingezeichnete Stellung verschiebbar. Sämtliche Kammern, nämlich die Behandlungsstationen 8,9,10, die Schleusenkammer 11, die Substratkammern 12,13,14,15, die Außenkammern 17,18,19,20 und der Innenzylinder 7 sind von einer gemeinsamen Bodenplatte und einer nicht dargestellten Deckplatte abgedeckt, so daß sich ein besonders einfacher Aufbau der Vorrichtung ergibt. Es ist klar, daß der Innenzylinder 7 mit mindestens einer eigenen, kreisscheibenförmigen Platte 51 mit der Motorwelle 52 in drehfester Verbindung stehen muß, damit das aus dem Innenzylinder 7 und den Substratkammern 12,13,14,15 bestehende Gebilde innerhalb der eigentlichen Vakuumkammer rotieren kann.

Das Substrat 2 wird zunächst bei geöffnetem Deckel 50 in die Substratkammer 12 eingeführt und wird dann bei geschlossenem Deckel 50 in Pfeilrichtung (im Uhrzeigersinn) transportiert, bis es sich vor der Kathode 46 befindet. In dieser Position bei evakuierter Kammer 13 wird ein Glimmprozeß nach dem Einlaß eines hierfür geeigneten Gases (z.B. O₂) aus dem Gastank 30 über die Rohrleitung 34 in die Behandlungsstation 8 durchgeführt und die Oberfläche des Substrats 2 für den Sputterprozeß in der Behandlungsstation 9 vorbereitet. Das für die Beschichtung erforderliche Aluminium wird von den Targets 53,54 nach einem Weiterdrehen des Innenzylinders 7 im Uhrzeigersinn um 90° abgesputtert, wobei das erforderliche Prozeßgas (Argon) vom Gasbehälter 31 aus über die Rohrleitung 35 zugeführt wird. Nach erfolgter Metall-Beschichtung wird die Substratkammer 12 in Pfeilrichtung um eine viertel Umdrehung weiter transportiert, bis das Substrat 2 der Elektrode 48 gegenüberliegt. In der Behandlungsstation 10 erfolgt der Plasmapolymerisationsprozeß, wozu zunächst ein erstes Ausgangssubstanz, z.B. Hexamethyldisiloxan, in die Prozeßkammer der Station 10 aus dem Tank 33 über die Leitung 37 mit Dosierventil 41 eingelassen wird. Als letzter Beschichtungsschritt wird der Gaseinlaß aus dem Tank 33 beendet und gleichzeitig der Einlaß einer zweiten Ausgangssubstanz, z.B. Methanol, ermöglicht. Schließlich wird der Gaseinlaß beendet und der Innenzylinder 7 um 90° weitergedreht, so daß die Kammer 13 vor der Ein-/Ausschleusöffnung 3 zu liegen kommt und das behandelte Substrat 2 gegen ein unbehandeltes Substrat 2^{x} ausgetauscht werden kann. Es ist klar, daß der Prozeß kontinuierlich abläuft, d.h. während ein Substrat mit einer Polymerisationsschicht in der Station 10 versehen wird, wird gleichzeitig ein Sputterprozeß in der Station 9 und ein Glimmprozeß in der Station 8 durchgeführt.

### Bezugszeichenliste

- 2,2'',...: Substrat
- 3: fensterförmige Öffnung
- 4: fensterförmige Öffnung
- 5: fensterförmige Öffnung
- 6: fensterförmige Öffnung
- 7: Vakuumkammer, Innenzylinder
- 8: Behandlungsstation
- 9: Behandlungsstation
- 10: Behandlungsstation
- 11: Ein-/Ausschleusstation
- 12: kastenförmige Substratkammer
- 13: kastenförmige Substratkammer
- 14: kastenförmige Substratkammer
- 15: kastenförmige Substratkammer
- 16: Außenzylinder
- 17: Außenkammer
- 18: Außenkammer
- 19: Außenkammer
- 20: Außenkammer
- 21,21',...: Außenwandteil
- 22: Kanal
- 23: Kanal
- 24: Kanal
- 25: Kanal
- 26: Rohrleitung
- 27: Rohrleitung
- 28: Rohrleitung
- 29: Rohrleitung
- 30: Vorratstank

- 31: Vorratstank
- 32: Vorratstank
- 33: Vorratstank
- 34: Gasleitung
- 35: Gasleitung
- 36: Gasleitung
- 37: Gasleitung
- 38: Gasdosierventil
- 39: Gasdosierventil
- 40: Gasdosierventil
- 41: Gasdosierventil
- 42: Sputterkathode
- 43: Sputterkathode
- 44: Stromversorgung
- 45: Außenwand
- 46: Glimmkathode
- 47: Stromversorgung
- 48: Elektrode
- 49: Stromgenerator, HF-Quelle
- 50: Deckel
- 51: kreisscheibenförmige Platte
- 52: Motorwelle
- 53: Target
- 54: Target

## Patentansprüche

1. Verfahren zur Schutzbeschichtung der Verspiegelungsschichten von Scheinwerferreflektoren mit Hilfe von Plasmapolymerisation, bei dem die in einer Vakuumkammer mittels Plasmapolymerisation einer organischen Siliziumverbindung auf die Verspiegelungsschicht aufgebrachte erste Schutzschicht in einem weiteren Verfahrensschritt in der selben Prozeßkammer unter Beibehaltung des Vakuums und unter Anwendung eines Plasmas mit einer zweiten, hydrophilen Schicht versehen wird, die im wesentlichen aus einem Kohlenwasserstoffgerüst und daran gebundenen polar wirkenden funktionellen Gruppen besteht.

2. Verfahren nach Anspruch 1, **dadurch gekennzeichnet, daß** die Herstellung der hydrophilen Schicht durch Plasmapolymerisation unter Einsatz von mindestens einer Ausgangssubstanz erfolgt, wobei die Ausgangssubstanz im wesentlichen aus einem Kohlenwasserstoffanteil und mindestens einer elekronegativen (d.h. im wesentlichen aus elektronegativen Elementen bestehenden) funktionellen Gruppe zusammengesetzt ist.

3. Verfahren nach Ansprüchen 1 und 2, **dadurch gekennzeichnet, daß** der Kohlenwasserstoffan-teil aliphatisch, cycloaliphatisch, aromatisch oder heterozyklisch ist.

4. Verfahren nach den Ansprüchen 1 bis 3, **dadurch gekennzeichnet, daß** als elektronegative funktionelle Gruppen vorgesehen werden: Halogen- (-F, -Cl, -Br,), Sulfid- (-S), Sulfoxy-(=SO-), Sulfon- (=SO₂), Amino- (insbesondere -NH₂ oder =NH, auch als Ring), Ester-(-COOR-), Ether- (C-O-C, auch als Ring, z.B. Oxiran), bevorzugt Carboxi- (-COOH), Carbonyl- (=C=O), Nitril- (-CN), besonders bevorzugt Nitro- (-NO₂), Amido- (-CONH₂) oder Hydroxi (-OH)-Gruppen.

5. Verfahren nach Anspruch 1, **dadurch gekennzeichnet, daß** die Herstellung der hydrophilen Schicht durch Plasmapolymerisation unter Einsatz eines Gemischs aus mindestens einer Kohlenwasserstoffverbindung und einer zusätzlichen Verbindung, die im wesentlichen aus einem oder mehreren elektronegativen Elementen (Halogene, bevorzugt aber Sauerstoff oder Stickstoff) besteht, erfolgt.

6. Verfahren nach den Ansprüchen 1 und 5, **dadurch gekennzeichnet, daß** als Kohlenwasserstoffverbindungen offenkettige oder zyklische Alkane, Alkine, oder Aromaten, bevorzugt aber offenkettige oder zyklische Alkene verwendet werden.

7. Verfahren nach den Ansprüchen 1 und 5, **dadurch gekennzeichnet, daß** als zusätzliche Verbindung O₂, CO₂, H₂O, N₂, N₂O oder Gemische hieraus, z.B. Luft, eingesetzt werden.

8. Verfahren nach Anspruch 1, **dadurch gekennzeichnet, daß** die Bildung der hydrophilen Schicht durch plasmainduzierte Polymerisation erfolgt, derart, daß unmittelbar nach Beendigung eines vorangegangenen Plasmas eine oder mehrere aliphatische, cycloaliphatische heterozyklische oder aromatische Ausgangssubstanzen mit jeweils mindestens einer elektronegativen funktionellen Gruppe und mit zusätzlich mindestens einer polymerisierbaren funktionellen Gruppe in die Prozeßkammer eingelassen werden.

9. Verfahren nach den Ansprüchen 1 und 8, **dadurch gekennzeichnet, daß** das der plasmainduzierten Polymerisation vorangehende Plasma gleich dem zur Plasmapolymerisation der Schutzschicht verwendeten Plasma ist.

10. Verfahren nach den Ansprüchen 1 und 8, **dadurch gekennzeichnet, daß** das der plasmainduzierten Polymerisation vorangehende Plasma ein kurzzeitiges Stickstoff- oder Edelgasplasma ist.

11. Verfahren nach den Ansprüchen 1 und 8, **dadurch gekennzeichnet, daß** als polymerisierbare Gruppen insbesondere C=C-Doppelbindungen, Epoxigruppen oder Thiirangruppen eingesetzt werden.

12. Verfahren nach den Ansprüchen 1 und 8, **dadurch gekennzeichnet, daß** bei Verwendung von Ausgangssubstanzen mit Epoxigruppen auf gesonderte elektronegative Gruppen in den Ausgangssubstanzen verzichtet wird.

13. Verfahren nach den Ansprüchen 1 und 8, **dadurch gekennzeichnet, daß** Halogen- (-F, -Cl, -Br, -I), Amin- (insbesondere -NH₂), Sulfoxy-(=SO), Sulfon- (=SO₂), bevorzugt jedoch Carboxi- (-COOH), Carbonyl- (-C=O), Nitril-(-CN), besonders bevorzugt Nitro- (-NO₂), Amid- (-CONH₂) oder Hydroxi- (-OH) als elektronegative Gruppen eingesetzt werden.

14. Vorrichtung zur Durchführung des Verfahrens nach den Ansprüchen 1 bis 13, **dadurch gekennzeichnet, daß** die Vakuumbehandlungsanlage mehrere, von einer ortsfesten kreiszylindrischen Vakuumkammerwand (16) gehaltene Behandlungsstationen (8,9,10) und einen von der Vakuumkammerwand (16) umschlossenen, drehbar gelagerten, vier Substratkammern (12 bis 15) tragenden Innenwandzylinder (7) aufweist, wobei in der Wand der Vakuumkammer (16) vier Öffnungen (3 bis 6) vorgesehen sind, mit denen die Substratkammern (12 bis 15) in Deckung bringbar sind und durch die die Behandlungsmittel auf die Substrate (2,2',..) einwirken können und mit einer die Vakuumkammerwand (16) von außen umschließenden und die von der Vakuumkammerwand (16) sich radial nach außen zu erstreckenden, die drei Behandlungsstationen (8,9,10) und die Ein-/Ausschleusstation (11) miteinander verbindenden Außenwand (21,21',...), wobei mindestens eine der zwischen der Außenwand, der Vakuumkammerwand und den Behandlungsstationen (8,9,10) vorgesehenen Außenkammern (16 bis 20) einerseits mit einer benachbarten Behandlungsstation und andererseits mit einer Gas- oder Ausgangssubstanz-Quelle (30 bis 33) verbunden ist.

15. Vorrichtung nach Anspruch 14, **dadurch gekennzeichnet, daß** der Innenzylinder (7) über einen auf der Grundplatte (51) gehaltenen Motor (52) um die Rotationsachse des Innenzylinders (7) drehbar ist, wobei die Außenkammern (17 bis 20) die Substratkammern (12 bis 15) und die Behandlungsstationen (8,9,10) in ihrer vertikalen Ausdehnung von einer gemeinsamen Boden- und einer gemeinsamen Deckplatte begrenzt sind, die fest oder zumindest druckdicht mit der Vakuumkammerwand (16), den Außenkammerwänden (21,21',...) und den Wänden der Behandlungsstationen verbunden sind.

16. Vorrichtung nach den Ansprüchen 14 und 15, **dadurch gekennzeichnet, daß** die erste Behandlungsstation (8) mit einer Elektrode (46) versehen und an eine Gasquelle (30) angeschlossen ist, die zweite Behandlungsstation (9) mit Sputterkathoden (42,43) ausgestattet und mit einer Gaseinlaßquelle (31) verbunden ist und die dritte Behandlungsstation (10) mit einer Elektrode (48) zur Erzeugung eines Plasmas und an zwei Prozeßgasquellen (32,33) angeschlossen ist, wobei in die Zuleitungen (36,37) von den Gasquellen (32,33) zu der Substratkammer (15) Gasdosierventile eingeschaltet sind.

## Claims

1. A process for providing a protective coating on the mirror layers of headlamp reflectors by plasma polymerisation, in which the first protective layer of an organic silicon compound applied onto the mirror layer in a vacuum chamber by means of plasma polymerisation is provided in a further process step in the same process chamber, while maintaining the vacuum and using a plasma, with a second, hydrophilic layer which substantially consists of a hydrocarbon skeleton and functional groups with a polar action attached thereto.

2. A process according to claim 1, **characterised in that** the hydrophilic layer is produced by plasma polymerisation using at least one starting substance, wherein the starting substance is substantially composed of a hydrocarbon moiety and at least one electronegative functional group (*i.e.* which substantially consists of electronegative elements).

3. A process according to claims 1 and 2, **characterised in that** the hydrocarbon moiety is aliphatic, cycloaliphatic, aromatic or heterocyclic.

4. A process according to claims 1 to 3, **characterised in that** the following are provided as electronegative functional groups: halogen (-F, -Cl, -Br), sulfide (-S), sulfoxy (=SO-), sulfone (=SO₂), amino (in particular -NH₂ or =NH, also as a ring), ester (-COOR-), ether (C-O-C, also as a ring, for example oxirane), preferably carboxy (-COOH), carbonyl (=C=O), nitrite (-CN), particularly preferably nitro (-NO₂), amido (-CONH₂) or hydroxy (-OH) groups.

5. A process according to claim 1, **characterised in that** the hydrophilic layer is produced by plasma polymerisation using a mixture of at least one hydrocarbon compound and an additional compound which substantially consists of one or more electronegative elements (halogens, but preferably oxygen or nitrogen).

6. A process according to claims 1 and 5, **characterised in that** open-chain or cyclic alkanes, alkynes, or aromatics, but preferably open-chain or cyclic alkenes, are used as the hydrocarbon compounds.

7. A process according to claims 1 and 5, **characterised in that** O₂, CO₂, H₂O, N₂, N₂O or mixtures thereof, for example air, are used as the additional compound.

8. A process according to claim 1, **characterised in that** the hydrophilic layer is formed by plasma-induced polymerisation in such a manner that, immediately after completion of a preceding plasma, one or more aliphatic, cycloaliphatic, heterocyclic or aromatic starting substances, each having at least one electronegative functional group and additionally at least one polymerisable functional group, are admitted into the process chamber.

9. A process according to claims 1 and 8, **characterised in that** the plasma preceding the plasma-induced polymerisation is identical to the plasma used for plasma polymerisation of the protective layer.

10. A process according to claims 1 and 8, **characterised in that** the plasma preceding the plasma-induced polymerisation is a transient nitrogen or noble gas plasma.

11. A process according to claims 1 and 8, **characterised in that** C=C double bonds, epoxy groups or thiiran groups are in particular used as the polymerisable groups.

12. A process according to claims 1 and 8, **characterised in that,** when starting substances comprising epoxy groups are used, no separate electronegative groups are provided in the starting substances.

13. A process according to claims 1 and 8, **characterised in that** that halogen (-F, -Cl, -Br, -I), amine (in particular -NH₂), sulfoxy (=SO), sulfone (=SO₂), but preferably carboxy (-COOH), carbonyl (-C=O), nitrile (-CN), particularly preferably nitro (-NO₂), amide (-CONH₂) or hydroxy (-OH) are used as the electronegative groups.

14. An apparatus for performing the process according to claims 1 to 13, **characterised in that** the vacuum treatment installation comprises two or more treatment stations (8, 9, 10) supported by a stationary circular-cylindrical vacuum chamber wall (16) and an internal wall cylinder (7), which is enclosed by the vacuum chamber wall (16), is rotatably mounted and bears four substrate chambers (12 to 15), wherein four openings (3 to 6) are provided in the wall of the vacuum chamber (16), with which openings the substrate chambers (12 to 15) may be aligned and through which the treatment agents can act upon the substrates (2, 2', ...), and further comprises an outer wall (21, 21', ...) which encloses the vacuum chamber wall (16) externally and extends radially outwards from the vacuum chamber wall (16) and connects together the three treatment stations (8, 9, 10) and the loading/unloading station (11), wherein at least one of the outer chambers (16 to 20) provided between the outer wall, the vacuum chamber wall and the treatment stations (8, 9, 10) is connected on the one hand to an adjacent treatment station and on the other to a source of gas or starting substance (30 to 33).

15. An apparatus according to claim 14, **characterised in that** the internal cylinder (7) is rotatable around the axis of rotation of the internal cylinder (7) by means of a motor (52) mounted on the base plate (51), wherein the vertical extent of the outer chambers (17 to 20), the substrate chambers (12 to 15) and the treatment stations (8, 9, 10) is delimited by a common bottom plate and a common top plate, which are firmly or at least pressure-tightly connected with the vacuum chamber wall (16), the outer chamber walls (21, 21', ...) and the walls of the treatment stations.

16. An apparatus according to claims 14 and 15, **characterised in that** the first treatment station (8) is provided with an electrode (46) and is connected to a gas source (30), the second treatment station (9) is equipped with sputtering cathodes (42, 43) and is connected to a gas inlet source (31) and the third treatment station (10) is provided with an electrode (48) for producing a plasma and is connected to two process gas sources (32, 33), wherein gas metering valves are fitted in the feed lines (36, 37) from the gas sources (32, 33) to the substrate chamber (15).

## Revendications

1. Procédé d'enduction de protection de couches réfléchissantes de réflecteurs de projecteurs à l'aide de polymérisation par plasma, selon lequel la première couche de protection déposée sur la couche réfléchissante au moyen de polymérisation par plasma dans une chambre à vide d'un composé de silicium organique, est prévue dans une autre étape de procédé dans la même chambre de traitement en maintenant le vide et en utilisant un plasma avec une deuxième couche hydrophile, qui est constituée principalement d'un squelette d'hydrocarbure et lié dessus des groupes fonctionnels actifs de manière polaire.

2. Procédé selon la revendication 1, **caractérisé en ce que** la préparation de la couche hydrophile par polymérisation par plasma a lieu par utilisation d'au moins une substance de départ, la substance de départ étant principalement composée d'une partie d'hydrocarbure et d'au moins un groupe fonctionnel électronégatif (c'est-à-dire constitué principalement d'éléments électronégatifs).

3. Procédé selon les revendications 1 et 2, **caractérisé en ce que** la partie d'hydrocarbure est aliphatique, cycloaliphatique, aromatique ou hétérocyclique.

4. Procédé selon les revendications 1 à 3, **caractérisé en ce que** sont prévus comme groupe fonctionnels électronégatifs : les groupes halogéno (-F, -Cl, -Br), sulfure, (-S), sulfoxy (=SO-), sulfone (=SO₂), amino (en particulier -NH₂ ou =NH, également comme cycle), ester (-COOR-), éther (C-O-C, également comme cycle, par exemple oxirane), de préférence carboxy (-COOH), carbonyle (=C=O), nitrile (-CN), en particulier de préférence nitro (-NO₂), amido (-CONH₂) ou hydroxy (-OH).

5. Procédé selon la revendication 1, **caractérisé en ce que** la préparation de la couche hydrophile par polymérisation par plasma a lieu en utilisant un mélange d'au moins un composé hydrocarboné et un composé additionnel, qui principalement est constitué d'un ou plusieurs éléments électronégatifs (un halogène, mais de préférence l'oxygène ou l'azote).

6. Procédé selon les revendications 1 et 5, **caractérisé en ce qu'**on utilise comme composés hydrocarbonés des alcanes, alcynes, à chaîne ouverte ou cycliques, ou des aromatiques, mais de préférence des alcènes à chaîne ouverte ou cycliques.

7. Procédé selon les revendications 1 et 5, **caractérisé en ce qu'**on utilise comme composé additionnel O₂, CO₂, H₂O, N₂, N₂O ou leurs mélanges, par exemple l'air.

8. Procédé selon la revendication 1, **caractérisé en ce que** la formation de la couche hydrophile par polymérisation par plasma a lieu de manière que directement après la cessation d'un plasma précédent on fait entrer dans la chambre de traitement une ou plusieurs substances de départ aliphatiques, cycloaliphatiques, hétérocycliques ou aromatiques avec chaque fois au moins un groupe fonctionnel électronégatif et avec en outre au moins un groupe fonctionnel polymérisable.

9. Procédé selon les revendications 1 et 8, **caractérisé en ce que** le plasma précédant la polymérisation induite par plasma est également le plasma utilisé pour la polymérisation par plasma de la couche protectrice.

10. Procédé selon les revendications 1 et 8, **caractérisé en ce que** le plasma précédant la polymérisation induite par plasma est un plasma d'azote gazeux ou de gaz rare temporaire.

11. Procédé selon les revendications 1 et 8, **caractérisé en ce qu'**on utilise comme groupe polymérisables en particulier des doubles liaisons C=C, des groupes époxy ou des groupes thiiranes.

12. Procédé selon les revendications 1 et 8, **caractérisé en ce qu'**on renonce aux groupes électronégatifs séparés pour l'utilisation de substances de départ avec des groupes époxy.

13. Procédé selon les revendications 1 et 8, **caractérisé en ce qu'**on utilise comme groupes électronégatifs les groupes halogéno (-F, -Cl, -Br), amino (en particulier -NH₂), sulfoxy (=SO-), sulfone (=SO₂), de préférence cependant carboxy (-COOH), carbonyle (=C=O), nitrile (-CN), en particulier de préférence nitro (-NO₂), amido (-CONH₂) ou hydroxy (-OH).

14. Dispositif pour effectuer le procédé selon les revendication 1 à 13, **caractérisé en ce que** le dispositif de traitement sous vide présente plusieurs stations de traitement (8, 9, 10) soutenues par une paroi de chambre de vide cylindrique circulaire fixe (16) et un cylindre interne (7) portant quatre chambres de substrat (12 à 15), placé mobile en rotation, contenu par la paroi de chambre de vide, dans la paroi de chambre de vide (16) étant prévues quatre ouvertures (3 à 6) avec lesquelles les chambres de substrat (12 à 15) peuvent être amenées en recouvrement et par lesquelles les moyens de traitement peuvent agir sur les substrats (2, 2', ...) et avec une des parois de chambre de vide (16) sont enfermées à l'extérieur et qui s'étendent radialement vers l'extérieur depuis la paroi de chambre de vide (16), les trois stations de traitement (8, 9, 10) et la station de charge/décharge (11) liant l'une avec l'autre les parois externes (21, 21' ...) ; où au moins une des chambres externes (16 à 20) prévues entre la paroi externe, la paroi de chambre de vide et les stations de traitement (8, 9, 10) est liée d'une part avec une station de traitement voisine et d'autre part avec une source (30 à 33) de gaz ou de substance de départ.

15. Dispositif selon la revendication 14, **caractérisé en ce que** le cylindre interne (7) est mobile en rotation via un moteur maintenu sur la plaque de base (51) autour de l'axe de rotation du cylindre interne (7), les chambres externes (17 à 20), les chambres de substrats (12 à 15) et les stations de traitement (8, 9, 10) sont limités dans leur extension verticale par une paque inférieure commune et une plaque supérieure commune, qui sont liées solidement ou au moins de manière étanche avec la paroi de chambre de vide (16), les parois de chambre externe (21, 21', ...) et les parois des stations de traitement.

16. Dispositif selon les revendications 14 et 15, **caractérisé en ce que** la première station de traitement (8) est prévue avec une électrode (46) et est raccordée sur une source de gaz (30), qui est équipée de deux stations de traitement (9) avec des cathodes de pulvérisation (42,43) et liée avec une source d'admission de gaz (31) et la troisième station de traitement (10) est reliée avec une électrode (48) pour engendrer un plasma et sur deux sources de gaz de traitement (32, 33), des vannes de dosage de gaz étant interposées dans les amenées (36, 37) de sources de gaz (32, 33) à la chambre de substrat (15).
